# EUROPÄISCHE PATENTANMELDUNG

(11) **EP 0 783 183 A2**
(43) Veröffentlichungstag der Anmeldung: **09.07.1997**
(21) Anmeldenummer: 96120098.7
(22) Anmeldetag: 13.12.1996
(51) Int. Cl.: H01L 33/00

(54) **Halbleiter-Bauelement und Verfahren zur Herstellung eines Halbleiter-Bauelementes**

(30) Priorität: 05.01.1996 DE 19600306
(71) Anmelder: SIEMENS AKTIENGESELLSCHAFT, 80333 München (DE)
(72) Erfinder: Späth, Werner, 83607 Holzkirchen (DE)

(57) **Zusammenfassung**

Die Erfindung bezieht sich auf ein Halbleiter-Bauelement (1) mit wenigstens einem mit einem Trägerteil (8) eines Bauelementgehäuses (15) befestigten Halbleiterchip (2), der elektrisch mit wenigstens zwei mit Anschlußkontakten (16) versehenen Elektrodenanschlußteilen (17) verbunden ist, wobei das Bauelementgehäuse (15) ein Gehäuseoberteil und wenigstens ein Gehäuseseitenteil aufweist, welche den Halbleiterchip (2) wenigstens bereichsweise umgeben. Das Trägerteil (8), an welchem der Halbleiterchip (2) befestigt ist, stellt gleichzeitig das Gehäuseoberteil des Bauelementgehäuses (15) dar, und die wenigstens zwei mit Anschlußkontakten (16) versehenen Elektrodenanschlußteile (17) sind wenigstens bereichsweise als Gehäuseseitenteile des Bauelementgehäuses (15) ausgebildet.

## Beschreibung

Die Erfindung bezieht sich auf ein Halbleiter-Bauelement und ein Verfahren zur Herstellung eines Halbleiter-Bauelementes mit wenigstens einem mit einem Trägerteil eines Bauelementgehäuses befestigten Halbleiterchip, der elektrisch mit wenigstens zwei mit Anschlußkontakten versehenen Elektrodenanschlußteilen verbunden ist, wobei das Bauelementgehäuse ein Gehäuseoberteil und wenigstens ein Gehäuseseitenteil aufweist, welche den Halbleiterchip wenigstens bereichsweise umgeben.

Integrierte Halbleiterschaltungen werden heute mit unterschiedlichen Gehäuseformen gefertigt, beispielsweise Kunststoff-Steckgehäusen mit beidseitigen Reihen von Elektrodenanschlußreihen, sogenannte Dual-Inline-Gehäuse, oder oberflachenmontierbare Kunststoffgehäusen in sogenannter SMD-Technologie ( 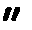 Surface Mounted Design-Technology"). Insbesondere bei optoelektronischen Bauelementen, wie beispielsweise lichtemittierende Infrarotdioden und dergleichen ist es bekannt, den die optoelektronische Schaltung tragenden Halbleiterchip in ein hermetisch dichtes TO-Metall-Bauteilgehäuse einzubauen. Hierbei werden als Chipträger aus Metall gefertigte Bodenplatten verwendet, die mit einer Metallkappe mit eingeglastem Filter montiert werden. Darüber hinaus sind in Massenstückzahlen gefertigte Kunststoff-Leuchtdioden mit geringeren Anforderungen an die optischen Qualitäten bekannt, bei denen das Gehäuse bestehend aus Bodenplatte und Kappe in einem Verfahrensgang gegossen und somit einteilig hergestellt wird. Der Einsatz von Leuchtdioden als punktförmige Lichtquellen, insbesondere für die Hinterleuchtung von Symbolen oder Anzeigen erfordert immer kleinere Gehäuse. Den derzeit üblichen Gehäusen aus umspritzten Leiterbänden oder aus Kunststoff gegossenen Gehäusen sind hinsichtlich der Miniaturisierung bereits aus Gründen der mechanischen und thermischen Stabilitätsanforderungen Grenzen gesetzt.

Der Erfindung liegt die Aufgabe zugrunde, ein Halbleiter-Bauelement mit einem den Halbleiterchip abstützenden bzw. schützenden Bauelementgehäuse zur Verfügung zu stellen, dessen äußere Abmessungen gegenüber den bisher bekannten Gehäusebauformen deutlich verringert sind, welches auch in hohen Stückzahlen kostengünstig herstellbar ist, und welches die vorbestimmten Anforderungen an die elektronischen und mechanischen Eigenschaften erfüllt, dabei eine einfache Vorratshaltung und Handhabbarkeit des Halbleiter-Bauelementes gewährleistet.

Diese Aufgabe wird durch eine Halbleiter-Bauelement gemäß Anspruch 1 und ein Verfahren zur Herstellung eines Halbleiter-Bauelementes nach Anspruch 11 gelöst.

Erfindungsgemäß ist vorgesehen, daß das Trägerteil, an welchem der Halbleiterchip befestigt ist, das Gehäuseoberteil des Bauelementgehäuses darstellt, und die wenigstens zwei mit Anschlußkontakten versehenen Elektrodenanschlußteile gleichzeitig wenigstens bereichsweise als Gehäuseseitenteile des Bauelementgehäuses ausgebildet sind. Dadurch, daß die Elektrodenanschlußteile des Halbleiter-Bauelementes, welche für den elektrischen Kontakt des Bauelementes mit einer Platine oder dergleichen vorgesehen sind, gleichzeitig als Bestandteile des Bauelementgehäuses ausgebildet werden, gelingt eine gegenüber den heute bekannten Gehäusebauformen wesentliche Verkleinerung des Bauelementgehäuses eines Halbleiter-Bauelementes. Vorzugsweise wird das erfindungsgemäße Bauelementgehäuse vermittels aus der Mikromechanik bekannten Methoden oder der aus der Fertigung des Halbleiterchips bekannten Verfahren hergestellt, so daß das Bauelementgehäuse äußere Abmessungen besitzt, welche in derselben Größenordnung liegen wie die Abmessungen des Halbleiterchips selbst. Die erfindungsgemäße Lösung ermöglicht eine Miniaturisierung eines Bauelementgehäuses, und gewährleistet gleichzeitig die für den Betrieb und die Handhabung des Halbleiter-Bauelements erforderlichen mechanischen und thermischen Stabilitätseigenschaften.

Dem Prinzip der Erfindung folgend kann vorgesehen sein, daß die wenigstens zwei Gehäuseseitenteile des Bauelement-Gehäuses als mikromechanische Stützpfosten mit einer die Bauhöhe des Halbleiterchips zumindest geringfügig überragenden Höhe ausgebildet sind, und an Randbereichen der dem Halbleiterchip zugewandten Oberfläche des Trägerteiles befestigt sind. Die Anzahl und Anordnung der als mikromechanische Stützpfosten ausgebildeten Gehäuseseitenteile des Bauelementgehäuses richtet sich nach der Art und dem Verwendungszweck der auf dem Halbleiterchip ausgebildeten elektronischen Schaltung und damit der Anzahl der erforderlichen Anschlußkontakte. Obzwar eine vorzugsweise Anwendung der Erfindung die Fertigung eines optoelektronischen Halbleiter-Bauelementes, insbesondere einer Leuchtdiode mit lediglich zwei Anschlußkontakten beinhaltet, können insbesondere bei komplizierteren Schaltkreisen mit einer Vielzahl von notwendigen Anschlußkontakten, mit denen die elektrische Verbindung zur Außenwelt hergestellt werden muß, eine entsprechende Anzahl von elektrisch voneinander isolierter Stützpfosten für die Ausbildung der Gehäuseseitenteile des Bauelementes vorgesehen sein.

Bei einer bevorzugten Ausbildung eines erfindungsgemäßen Bauelementes kann vorgesehen sein, daß die wenigstens zwei Gehäuseseitenteile aus einem elektrisch leitenden Material hergestellt sind, und an ihrem freien, dem Trägerteil des Bauelementgehäuses abgewandten Ende mit Anschlußkontakten versehen sind. Zur Vermeidung eines elektrischen Kurzschlusses zwischen den elektrisch leitenden Gehäuseseitenteilen sind diese entweder mit einem gewissen Abstand voneinander angeordnet, so daß die zwischenliegende Luftschicht als Isolation wirkt, oder es ist eine zwischen den Gehäuseseitenteilen angeordnete, vorzugsweise dünne, elektrisch isolierende Schicht, beispielsweise aus einem Kunststoffmaterial, vorgesehen. Die an dem freien Ende der Gehäuseseitenteile angebrachten Anschlußkontakte aus elektrisch leitendem Material können hierbei in der Form von Lötpolstern vorliegen, die vorzugsweise galvanisch oder durch Eintauchen des freien Endes der Gehäuseseitenteile in ein Lötbad aufgebracht sind. Vermittels der Lötpolster kann das Halbleiter-Bauelement direkt mit entsprechend geformten Lötstellen auf einer Platine verlötet werden.

In weiterer Ausgestaltung der Erfindung kann vorgesehen sein, daß die wenigstens zwei Gehäuseseitenteile vermittels einer aus elektrisch leitendem Material hergestellten Anschlußverbindung elektrisch mit dem auf dem Trägerteil des Bauelementgehäuses befestigten Halbleiterchip verbunden sind. Vorzugsweise besitzt die aus elektrisch leitendem Material hergestellte Anschlußverbindung eine auf der dem Halbleiterchip zugewandten Oberfläche des Trägerteiles ausgebildete metallische Leiterbahnschicht mit einer geringen Stärke von etwa bis zu 1 µm, welche vorzugsweise durch die aus der Fertigung von Halbleiterschaltungen bekannten photolithographischen Verfahren hergestellt ist. Hierzu wird auf der dem Halbleiterchip zugewandten Oberfläche des Trägerteils ganzflächig eine Abdeck- oder Maskierschicht abgeschieden, strukturiert, und ganzflächig eine Metallschicht abgeschieden. Nach Entfernen der Abdeck- oder Maskierungsschicht mit der kantenkonform darauf abgeschiedenen Metallisierung verbleiben die auf der Oberfläche des Trägerteiles verbleibenden Leiterbahnen mit der gewünschten Struktur. Diese ist insbesondere streifenförmig so angeordnet bzw. ausgebildet, daß eine elektrische Verbindung mit den entsprechend auf der Oberfläche des Halbleiterchips zugeordneten Kontaktanschlußstellen (Pads) auf einfache Weise möglich ist. Darüber hinaus kann vorgesehen sein, daß insbesondere auf der dem Trägerteil abgewandten Oberfläche des Halbleiterchips weitere Kontaktstellen (Bondpads) ausgebildet sind, welche vermittels Bonddrähten mit Kontaktstellen der Anschlußverbindung elektrisch verbunden werden.

Insbesondere bei optoelektronischen Halbleiterbauelementen kann es von Vorteil sein, sowohl die Leiterbahnen der auf der dem Halbleiterchip zugewandten Oberfläche des Trägerteiles angeordneten Anschlußverbindung, als auch die auf der Oberfläche des Halbleiterchips entsprechend zugeordneten Kontaktanschlußstellen als dünne, vorzugsweise parallel verlaufende Streifen auszubilden, wobei die Streifen der Anschlußverbindung und die Streifen der Kontaktanschlußstellen des Halbleiterchips quer zueinander verlaufend ausgeführt sein können. Auf diese Weise kann eine sichere elektrische und mechanische Kontaktierung der Anschlußverbindung und des Halbleiterchips unter Berücksichtigung der Justagetoleranzen bewerkstelligt werden, und gleichzeitig ein Verlust von in den Halbleiterchip eintretenden oder austretenden Licht aufgrund von Absorption in den elektrisch leitenden Schichten verringert werden.

Von Vorteil kann vorgesehen sein, daß die wenigstens zwei Gehäuseseitenteile des Bauelementgehäuses aus einem Material hergestellt sind, welches einen wenigstens annähernd gleichen Ausdehnungskoeffizienten wie das Material des Trägerteiles besitzt. Auf diese Weise können Probleme hinsichtlich der mechanischen Stabilität des Bauelementes bei der Kontaktierung auf eine Platine oder dergleichen oder beim Betrieb des Bauelementes, welcher in der Regel mit einer Wärmeerzeugung verbunden ist, vermieden werden.

Vorzugsweise besteht das Trägerteil aus einem Material, welches ein Hartlöten mit den Elektrodenanschlußteilen ermöglicht. Als besonders vorteilhaft kann als Material für das Trägerteil Glas verwendet werden; darüber hinaus ist jedoch auch ein Kunststoffmaterial, insbesondere ein hochtemperaturstabiles Kunststoffmaterial für das Trägerteil möglich. Für das Material der Elektrodenanschlußteile wird insbesondere ein Halbleitermaterial, namentlich Silizium bevorzugt, welches durch Dotierung elektrisch leitende Eigenschaften besitzen kann. Im Prinzip geeignet als Material für die Elektrodenanschlußteile ist aber auch ein anderes elektrisch leitfähiges Material, welches insbesondere den gleichen oder wenigstens annähernd gleichen Ausdehnungskoeffizienten wie das Material des Trägerteiles besitzt.

Der Verwendung von Glas oder einem optisch transparenten oder wenigstens durchscheinenden Kunststoffmaterial für das Trägerteil wird insbesondere dann der Vorzug gegeben, wenn der auf seiner dem Trägerteil des Bauelementgehäuses zugewandten Oberfläche befestigte Halbleiterchip eine optoelektronische Schaltung umfaßt. In diesem Fall kann vorteilhafterweise das Trägerteil auf seiner dem Halbleiterchip abgewandten Oberfläche mit einer optischen Abbildungseinrichtung versehen sein, beispielsweise einer Bulk-, Fresnel-, oder diffraktiven Linse. Zur Ausbildung der Abbildungseinrichtung auf der Trägeroberseite kann eine Kunststoffschicht mit einer Stärke von einigen µm aufgebracht sein, in welche vermittels eines Prägestempels die geeigneten optischen Strukturen zur Abbildung eines Lichtstrahls eingeprägt sein können. Daneben kann die Abbildungseinrichtung auch vermittels einer Form- oder Gußtechnik auf die Oberseite des Trägerteils aufgebracht sein.

Vorzugsweise besteht das Trägerteil des Bauelementgehäuses aus einem elektrisch isolierendem Material. Bei besonderen Anwendungen kann das Material des Trägerteiles auch elektrisch leitend sein; in diesem Fall muß zur Vermeidung eines elektrischen Kurzschlusses vor dem Auftrag der Anschlußverbindung auf der dem Halbleiterchip zugewandten Oberfläche des Trägerteils eine dünne Isolationsschicht aufgebracht sein. Beispielsweise bei der Anwendung eines optoelektronischen Halbleiterchips mit einer IRED-Schaltung mit einer Wellenlänge des Lichtstrahles von typischerweise λ > 1100 nm kann das Trägerteil aus einem Halbleitermaterial, insbesondere Silizium bestehen, in welches gegebenenfalls geeignete Linsen (refraktiv oder diffraktiv) geätzt sind. Die elektrische Trennung von Anode und Kathode der IRED-Schaltung kann hierbei vorzugsweise durch Auftragen einer Oxidisolation auf dem Siliziummaterial des Trägerteils erfolgen. Solche Bauelemente können insbesondere als Sendebauelemente in optoelektronischen Nachrichtenübertragungssystemen eingesetzt werden.

Das erfindungsgemäße Verfahren ermöglicht die gleichzeitige Herstellung einer Vielzahl von Halbleiter-Bauelementen mit einem miniaturisierten Bauelementgehäuse. Das Verfahren zeichnet sich durch folgende Verfahrensschritte aus:
- Herstellen einer Trägerplatte aus elektrisch isolierendem Material,
- Ausbilden einer strukturierten Leiterbahnschicht mit Leiterbahnen auf der dem Halbleiterchip zugewandten Oberfläche der Trägerplatte,
- separat von der Herstellung der Trägerplatte, Herstellung einer Elektrodenanschlußplatte,
- Fertigen von Vertiefungen im Bereich der den Leiterbahnen zugeordneten Oberfläche der Elektrodenanschlußplatte,
- Verbinden der mit der Leiterbahnschicht versehenen Oberfläche der Trägerplatte mit der mit den Vertiefungen versehenen Oberfläche der Elektrodenanschlußplatte.

Vorzugsweise erfolgt die elektrische und mechanische Verbindung von Trägerplatte und Elektrodenanschlußplatte durch einen Lötschritt. Hierbei wird die Trägerplatte und die Elektrodenanschlußplatte so zueinander justiert ausgerichtet, daß die auf der dem Halbleiterchip zugewandten Oberfläche der Trägerplatte ausgebildeten Leiterbahnen an der richtigen Stelle bezüglich der Vertiefungen der Elektrodenanschlußplatte zu liegen kommen. Daran anschließend werden die beiden Platten unter Druck auf eine bestimmte Temperatur von beispielsweise 400° Celsius erhitzt und miteinander verlötet. Nach der Fertigstellung der Verbindung der Platten können die den Vertiefungen entsprechenden Abschnitte der Elektrodenanschlußplatte entfernt werden, insbesondere durch einen Sägevorgang, und daran anschließend kann die Trägerplatte zur Fertigung der einzelnen Halbleiter-Bauelemente zerteilt werden, vorzugsweise wiederum durch einen Sägevorgang.

Noch vor der Unterteilung der Trägerplatte können auf die elektrisch leitenden Elektrodenanschlußteile die Anschlußkontakte aufgebracht werden, insbesondere Lötpolster, die galvanisch oder durch Eintauchen in ein Lötbad gefertigt werden. Weiterhin können nach diesem Schritt, aber noch vor dem Unterteilen der Trägerplatte die einzelnen Halbleiter-Bauelemente auf eine Kunststoffolie geklebt werden, um die Vorratshaltung bzw. Handhabung der einzelnen Halbleiter-Bauelemente zu vereinfachen. Hierbei können die Halbleiter-Bauelemente bei Bedarf einzeln von der Kunststoffolie entnommen und direkt auf eine Platine oder dergleichen abgelegt und verlötet werden (sogenanntes Pick- und Place-Verfahren).

Weitere Vorteile, Merkmale und Zweckmäßigkeiten der Erfindung ergeben sich aus der Beschreibung eines Ausführungsbeispieles anhand der Zeichnung. Es zeigt:
- Figur 1: eine schematische Schnittansicht eines Halbleiter-Bauelementes gemäß einem Ausführungsbeispiel der Erfindung mit einem optoelektronischen Halbleiterchip;
- Figur 2: eine schematische Schnittansicht zur Erläuterung des erfindungsgemäßen Verfahrens zur Herstellung einer Vielzahl von Halbleiter-Bauelementen gemaß Ausführungsbeispiel;
- Figur 3A und 3B: eine schematische Unteransicht und Draufsicht in Blickrichtung IIIA-IIIA und IIIB-IIIB nach Figur 1; und
- Figur 4: eine schematische Draufsicht in Blickrichtung IV-IV nach Figur 2.

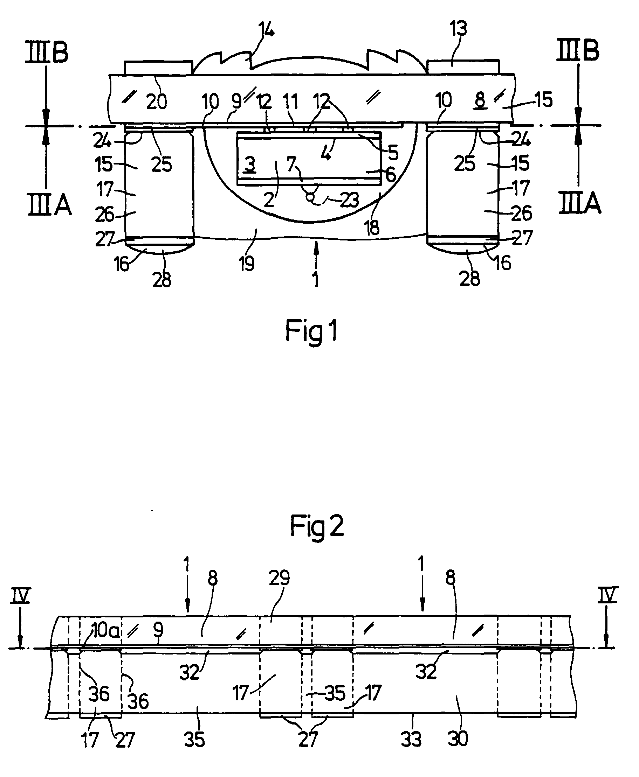

Das in Figur 1 dargestellte Ausführungsbeispiel der Erfindung umfaßt ein Halbleiter-Bauelement 1 in Form einer Leuchtdiode mit einem Halbleiterchip 2, der einen auf einem Siliziumsubstrat 3 ausgebildeten pn-Übergang 4, sowie eine der Lichtaustrittsseite der Leuchtdiode zugeordneten p-dotierte Anodenschicht 5 und einer der Rückseite der Leuchtdiode zugeordnete, n-dotierte Kathodenschicht 6 besitzt, an die sich eine rückseitige Kontaktierungsschicht 7 anschließt. Es ist ein aus Glas hergestelltes Trägerteil 8 vorgesehen, auf dessen Unterseite 9 eine aus elektrisch leitendem Material hergestellte Anschlußverbindung 10 mit einer Struktur ausgebildet ist, welche dünne, parallel zueinander verlaufende Leiterbahnen 11 besitzt. Die Anschlußverbindung 10 stellt eine dünne Schicht aus einem Metall dar, welches eine gute Haftung mit der Glasplatte 8 gewährleistet, vorzugsweise aus Titan bzw. Chrom-Platin-Gold oder Titan-Palladium-Gold. Auf der Anodenschicht 5 des Halbleiterchips 2 sind dünne, parallel zueinander und quer zur Richtung der Leiterbahnen 11 verlaufende Kontaktanschlußelemente 12 ausgebildet. Der Halbleiterchip 2 ist an der Unterseite 9 des Trägerteils 8 mechanisch fest mit diesem verbunden, und zwar dergestalt, daß die Leiterbahnen 11 zu den quer hierzu verlaufenden Kontaktanschlußelementen 12 sicheren elektrischen Kontakt besitzen. Auf der Oberseite 20 des Trägerteiles 8 ist eine für die Strahlung transparente Kunststoffschicht 13 aufgebracht, in welche vermittels eines Prägestempels geeignete Strukturen zur Ausbildung einer Fresnellinse 14 oder einer anderen geeigneten Linseneinrichtung zur gewünschten Abbildung des von der Leuchtdiode ausgehenden Lichtstrahls eingeprägt sind. Das Bauelementgehäuse 15 des Halbleiter-Bauelementes 1 umfaßt des weiteren zwei mit Anschlußkontakten 16 versehene Elektrodenanschlußteile 17, welche die beiden Gehäuseseitenteile des Bauelementgehäuses 15 darstellen. Das Trägerteil 8 bildet das das Bauelementgehäuse 15 nach oben abschließende Gehäuseoberteil, welches zusammen mit den beiden Gehäuseseitenteilen den Halbleiterchip 2 schützend umgibt. Zum Schutz des Halbleiterchips 2 ist dieser mit einem transparenten Kunststoffmaterial 18 überdeckt, der auch den Bereich zwischen der Lichtaustrittsseite der Leuchtdiode und der Anschlußverbindung 10 ausfüllt. Der verbleibende Hohlraum des Bauelementes 1 zwischen den Gehäuseseitenteilen ist mit einem elektrisch nichtleitenden, nicht notwendigerweise transparenten Material 19, inbesondere Kunststoffmaterial aufgefüllt.

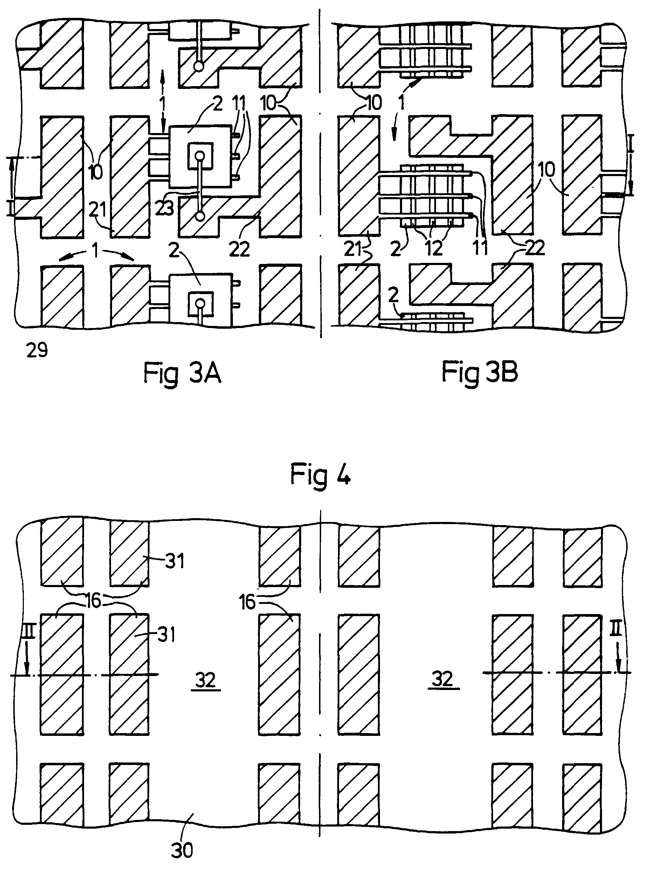

Die elektrisch leitende Anschlußverbindung 10 ist in Form einer auf die Unterseite 9 des Trägerteiles 8 aufgebrachten metallischen Schicht mit einer Stärke von wenigen µm ausgebildet, die vermittels einer Phototechnik mit Strukturen versehen ist; diese besitzt, wie insbesondere aus den Figuren 3A und 3B ersichtlich ist, neben einer Vielzahl von Leiterbahnen 11, welche parallel zueinander verlaufen, einen hiermit elektrisch angeschlossenen Anschlußbereich 21, sowie einen Anschlußbereich 22, der über einen Bonddraht 23 elektrisch mit der auf der Rückseite des Halbleiterchips 2 aufgebrachten Kontaktierungsschicht 7 verbunden ist. Die Anschlußverbindung 10 wird vorzugsweise über eine auf das Trägerteil 8 bedampfte Titan bzw. Chrom-Platin-Gold- oder Titan-Palladium-Gold-Schicht hergestellt. Die Anschlußbereiche 21 und 22 besitzen eine den Stirnseiten 24 der Elektrodenanschlußteile 17 entsprechende Formgebung und Ausdehnung. Die Stirnseiten 24 der Elektrodenanschlußteile 17 sind mit einer dünnen Metallschicht 25, insbesondere aus Gold-Silizium überzogen, um durch Hartlöten eine mechanisch stabile und dauerhafte Verbindung der Elektrodenanschlußteile 17 auf der Unterseite 9 an den Randbereichen des Trägerteiles 8 zu gewährleisten. Die Elektrodenanschlußteile 17 bestehen aus einem elektrisch leitfähigen Material, welches den gleichen Ausdehnungskoeffizienten wie das Material des Trägerteiles 8 besitzt. Im dargestellten Falle von Glas für das Trägerteil 8 bestehen die Elektrodenanschlußteile 17 aus einem Halbleitermaterial wie beispielsweise Silizium, welches zur Erhöhung der elektrischen Leitfähigkeit dotiert ist, beispielsweise n⁺-dotiert. Die freien Enden 26 der Elektrodenanschlußteile 17 sind zur Erhöhung der Haftung mit den Anschlußkontakten 16 mit einer metallischen Zwischenschicht 27 überzogen, im dargestellten Falle beispielsweise aus Titan-Platin-Zinn-Palladium. Auf der Zwischenschicht 27 sind die Anschlußkontakte 16 in Form von Lötpolstern 28 aufgebracht, vermittels derer die elektrische Verbindung des Halbleiter-Bauelementes 1 mit Lötstellen, die auf einer Platine oder dergleichen angebracht sind, ermöglicht wird. Die Elektrodenanschlußteile 17 bilden die beiden Gehäuseseitenteile des Bauelementgehäuses 15 in der Form von mikromechanischen Stützpfosten mit einer die Bauhöhe des Halbleiterchips 2 wenigstens geringfügig überragenden Höhe. Die äußeren Gesamtabmessungen des erfindungsgemäßen Halbleiter-Bauelementes 1 liegen somit in derselben Größenordnung wie die Abmessungen des Halbleiterchips 2 selbst, also beispielsweise in der Größenordnung von 500 µm · 500 µm · 100 µm.

Unter Bezugnahme auf Figur 2 und Figur 4 wird das erfindungsgemäße Verfahren zur Herstellung einer Vielzahl von Halbleiter-Bauelementen der in Figur 1 gezeigten Struktur näher erläutert. Zunächst wird eine vorzugsweise aus Glas bestehende Trägerplatte 29, aus der später die Trägerteile 8 der einzelnen Halbleiter-Bauelemente 1 gebildet werden, mit einer elektrisch leitenden Schicht geringer Stärke versehen, aus der die Anschlußverbindung 10 für die einzelnen Halbleiter-Bauelemente 1 hergestellt wird. Hierzu wird die dem Halbleiterchip 2 zugewandte Oberfläche 9 der Trägerplatte 29 vollflächig mit einer dünnen Metallschicht 10a aus Titan-Platin-Gold oder Titan-Palladium-Gold bedampft, welche Metallschicht mit photolithographischen Methoden in der aus den Figuren 3A und 3B ersichtlichen Anordnung strukturiert wird. Auf diese Weise werden die Anschlußverbindungen 10 mit Leiterbahnen 11, Anschlußbereichen 21 und 22 hergestellt.

Separat und unabhängig von der Herstellung der Trägerplatte 29 wird in einem eigenen Verfahrensschritt die Elektrodenanschlußplatte 30 gefertigt, aus der die Elektrodenanschlußteile 17 für die einzelnen Halbleiter-Bauelemente 1 gebildet werden. Die Elektrodenanschlußplatte 30 stellt vorzugsweise einen dünnen Silizium-Wafer mit denselben äußeren Abmessungen wie die Glasplatte 29 dar. Auf der dem Halbleiterchip 2 zugewandten Oberfläche 20 der Elektrodenanschlußplatte 30 wird zunächst eine dünne leitende Schicht vollflächig aufgetragen, beispielsweise aus Gold-Zinn. Auf diese dünne Metallschicht wird vollflächig eine Photolackschicht aufgetragen, welche unter Verwendung einer geeigneten Maske derart strukturiert wird, daß sich die in Figur 4 dargestellte Anordnung ergibt. Der strukturierte Photolack 31 wird in einem nachfolgenden Ätzschritt als Ätzmaske zur Entfernung von nicht durch die Photolackschicht abgedeckten Bereichen der Gold-Zinn-Schicht und zur Ausbildung von Vertiefungen 32 in die Oberfläche der Elektrodenanschlußplatte 30 verwendet. Die Tiefe der Vertiefungen 32 ist wenigstens geringfügig größer als die Höhe der Leiterbahnen 11 und beträgt beispielsweise 10 bis 50 µm. Zur Fertigstellung der Elektrodenanschlußplatte 30 wird diese auf ihrer Rückseite 33 über einen weiteren Photolithographieschritt mit der metallischen Zwischenschicht 27 zur Erhöhung der Haftung mit den später aufgebrachten Anschlußkontakten 16 versehen.

Nach Fertigstellung der Elektrodenanschlußplatte 30 wird diese mit der Trägerplatte 29 fixiert, vorzugsweise durch Hartlöten. Hierzu werden die beiden Platten 29 und 30 so zueinander justiert ausgerichtet, daß die Anschlußbereiche 21 und 22 über die entsprechend gestalteten Anschlußkontakte 34 der Elektrodenanschlußplatte 30 und damit die Leiterbahnen 11 innerhalb des Raumes der Vertiefung zu liegen kommen. Anschließend werden beide Platten unter Druck auf etwa 400° Celsius erwärmt und miteinander verlötet. Nach diesem Schritt ergibt sich die in Figur 2 im Schnitt schematisch dargestellte Anordnung. Daran anschließend werden die Abschnitte 35 zwischen den Anschlußkontakten 16 der Elektrodenanschlußplatte 17 an der gestrichelten Linie 36 entlang herausgesägt, so daß die Elektrodenanschlußteile 17 stehen bleiben.

Danach können die einzelnen Halbleiterchips 2 mit ihrer Lichtaustrittsseite auf das Trägerteil 8 gelötet werden. Hierzu werden die Halbleiterchips 2 erwärmt, vorzugsweise vermittels eines Hochleistungslasers. Daran anschließend werden Bonddrähte 23 zur elektrischen Verbindung der rückseitigen Kontaktierungsschicht 7 mit dem Anschlußbereich 22 gezogen, und es wird der Halbleiterchip 2 mit einem transparenten Kunststoffmaterial 18 vergossen, welches wegen der besseren Lichtauskopplung auch den Zwischenraum zwischen der Lichtaustrittsseite des Halbleiterchips 2 und dem Trägerteil 8 ausfüllt. Oberhalb des transparenten Kunststoffmaterials 18 kann des weiteren ein Kunststoffmaterial 19 mit einem geringem Ausdehnungskoeffizienten eingefüllt werden, wobei die Menge des einzufüllenden Materials 19 genau auf die äußeren Dimensionen des Halbleiterchips 2 abzustimmen ist.

Abschließend werden auf den Elektrodenanschlußteilen 17 Lötpolster 16 galvanisch oder durch Eintauchen in ein Lötbad aufgebracht, die Trägerplatte 29 auf eine (nicht näher dargestellte) Kunststoffolie geklebt und anschließend in die einzelnen Halbleiter-Bauelemente zersägt.

## Patentansprüche

1. Halbleiter-Bauelement (1) mit wenigstens einem mit einem Trägerteil (8) eines Bauelementgehäuses (15) befestigten Halbleiterchip (2), der elektrisch mit wenigstens zwei mit Anschlußkontakten (16) versehenen Elektrodenanschlußteilen (17) verbunden ist, wobei das Bauelementgehäuse (15) ein Gehäuseoberteil und wenigstens ein Gehäuseseitenteil aufweist, welche den Halbleiterchip (2) wenigstens bereichsweise umgeben,
dadurch gekennzeichnet, daß
das Trägerteil (8), an welchem der Halbleiterchip (2) befestigt ist, gleichzeitig das Gehäuseoberteil des Bauelementgehäuses (15) darstellt, und die wenigstens zwei mit Anschlußkontakten (16) versehenen Elektrodenanschlußteile (17) wenigstens bereichsweise als Gehäuseseitenteile des Bauelementgehäuses (15) ausgebildet sind.

2. Halbleiter-Bauelement (1) nach Anspruch 1, dadurch gekennzeichnet, daß die wenigstens zwei Gehäuseseitenteile des Bauelementgehäuses (15) als mikromechanische Stützpfosten mit einer die Bauhöhe des Halbleiterchips (2) zumindest geringfügig überragenden Höhe ausgebildet sind, und an Randbereichen der dem Halbleiterchip (2) zugewandten Oberfläche des Trägerteiles (8) befestigt sind.

3. Halbleiter-Bauelement (1) nach Anspruch 1 oder 2, dadurch gekennzeichnet, daß die wenigstens zwei Gehäuseseitenteile aus einem elektrisch leitenden Material hergestellt sind, und an ihrem freien, dem Trägerteil (8) des Bauelementgehäuses (15) abgewandten Ende mit Anschlußkontakten (34) versehen sind.

4. Halbleiter-Bauelement (1) nach Anspruch 1 bis 3, dadurch gekennzeichnet, daß die wenigstens zwei Gehäuseseitenteile vermittels einer aus elektrisch leitendem Material hergestellten Anschlußverbindung (10) elektrisch mit dem auf dem Trägerteil (8) des Bauelementgehäuses (15) befestigten Halbleiterchip (2) verbunden sind.

5. Halbleiter-Bauelement (1) nach Anspruch 4, dadurch gekennzeichnet, daß die aus elektrisch leitendem Material hergestellte Anschlußverbindung (10) eine auf der dem Halbleiterchip (2) zugewandten Oberfläche des Trägerteiles (8) ausgebildete Leiterbahnschicht aufweist.

6. Halbleiter-Bauelement (1) nach Anspruch 1 bis 5, dadurch gekennzeichnet, daß die wenigstens zwei Gehäuseseitenteile des Bauelementgehäuses (15) aus einem Material hergestellt sind, welches einen wenigstens annähernd gleichen Ausdehnungskoeffizienten wie das Material des Trägerteiles (8) besitzt.

7. Halbleiter-Bauelement (1) nach Anspruch 1 bis 6, dadurch gekennzeichnet, daß die wenigstens zwei Gehäuseseitenteile des Bauelementgehäuses (15) aus einem Halbleitermaterial hergestellt sind.

8. Halbleiter-Bauelement (1) nach Anspruch 1 bis 7, dadurch gekennzeichnet, daß der Halbleiterchip (2) auf seiner dem Trägerteil (8) des Bauelementgehäuses (15) zugewandten Oberfläche eine optoelektronische Schaltung aufweist, und das Trägerteil (8) wenigstens im Bereich des befestigten Halbleiterchips (2) aus einem optisch transparenten oder wenigstens durchscheinenden Material hergestellt ist.

9. Halbleiter-Bauelement (1) nach Anspruch 8, dadurch gekennzeichnet, daß das Trägerteil (8) auf seiner dem Halbleiterchip (2) abgewandten Oberfläche mit einer optischen Abbildungseinrichtung versehen ist.

10. Halbleiter-Bauelement (1) nach Anspruch 1 bis 9, dadurch gekennzeichnet, daß das Trägerteil (8) des Bauelementgehäuses (15) eine elektrisch isolierende Glas- oder Kunststoffplatte darstellt.

11. Verfahren zur Herstellung eines Halbleiter-Bauelementes (1) mit wenigstens einem mit einem Trägerteil (8) eines Bauelementgehäuses (15) befestigten Halbleiterchip (2), der elektrisch mit wenigstens zwei mit Anschlußkontakten (34) versehenen Elektrodenanschlußteilen (17) verbunden wird, wobei das Bauelementgehäuse (15) ein Gehäuseoberteil und wenigstens ein Gehäuseseitenteil aufweist, welche den Halbleiterchip (2) wenigstens bereichsweise umgeben,
dadurch gekennzeichnet, daß
das Trägerteil (8), an welchem der Halbleiterchip (2) befestigt wird, gleichzeitig das Gehäuseoberteil des Bauelementgehäuses (15) darstellt, und die wenigstens zwei mit Anschlußkontakten (34) versehenen Elektrodenanschlußteile (17) wenigstens bereichsweise als Gehäuseseitenteile des Bauelementgehäuses (15) ausgebildet werden.

12. Verfahren zur Herstellung einer Vielzahl von Halbleiter-Bauelementen (1) nach den Ansprüchen 1 bis 11, gekennzeichnet durch die Verfahrensschritte:
- Herstellen einer Trägerplatte (29) aus elektrisch isolierendem Material,
- Ausbilden einer strukturierten Anschlußverbindungsschicht (10) mit Leiterbahnen (11) auf der dem Halbleiterchip (2) zugewandten Oberfläche (9) der Trägerplatte (29),
- separat von der Herstellung der Trägerplatte (29), Herstellung einer Elektrodenanschlußplatte (30),
- Fertigen von Vertiefungen im Bereich der den Leiterbahnen (11) zugeordneten Oberfläche (9) der Elektrodenanschlußplatte (30),
- Verbinden der mit der Anschlußverbindungsschicht (10) versehenen Oberfläche (9) der Trägerplatte (29) mit der mit den Vertiefungen versehenen Oberfläche der Elektrodenanschlußplatte (30).

13. Verfahren nach Anspruch 12, dadurch gekennzeichnet, daß die Trägerplatte (29) und die Elektrodenanschlußplatte (30) miteinander verlötet werden.

14. Verfahren nach Anspruch 12 oder 13, dadurch gekennzeichnet, daß die Trägerplatte (29) und die Elektrodenanschlußplatte (30) vor der Verbindung einer Erwärmung und/oder einem Druck ausgesetzt werden.

15. Verfahren nach Anspruch 12 bis 14, dadurch gekennzeichnet, daß nach der Verbindung von Trägerplatte (29) und Elektrodenanschlußplatte (30) die den Vertiefungen entsprechenden Bereiche der Elektrodenanschlußplatte (30) entfernt werden.

16. Verfahren nach Anspruch 12 bis 15, dadurch gekennzeichnet, daß die Trägerplatte (29) zur Fertigung von einzelnen Halbleiter-Bauelementen (1) zerteilt wird.
